# EUROPEAN PATENT SPECIFICATION

(11) **EP 4 007 149 B1**
(45) Date of publication and mention of the grant of the patent: **22.05.2024**
(21) Application number: 22152934.0
(22) Date of filing: 24.02.2016
(51) Int. Cl.: H02M 7/00, H05K 7/20

(54) **INVERTER**
WECHSELRICHTER
CONVERTISSEUR

(30) Priority: 15.06.2015 CN 201520412624 U
(43) Date of publication of application: 01.06.2022
(62) Divisional of application: 16157092.4
(73) Proprietor: Sungrow Power Supply Co., Ltd., Hefei, Anhui 230088 (CN)
(72) Inventor: DONG, Puyun, Hefei, 230088 (CN); LI, Yonghong, Hefei, 230088 (CN); ZHOU, Hao, Hefei, 230088 (CN); MAO, Jianhua, Hefei, 230088 (CN)
(74) Representative: Zacco Norway AS

(56) References cited:
- EP-A2- 1 283 589
- WO-A1-2009/136815
- CN-U- 202 816 620
- GB-A- 2 385 469
- US-A- 4 772 999
- US-A1- 2012 002 452
- US-A1- 2014 321 065

## Description

### FIELD

The disclosure relates to the technical field of power electronic technology, and in particular to an inverter.

### BACKGROUND

An inverter in the conventional technology mainly includes an electronic device, a magnetic element, a heat radiator and a box. There are two common arrangements for the inverter as follows.

In one arrangement, the electronic device and the magnetic element are disposed in a box, and the heat radiator is disposed outside the box. With this arrangement, most of heat generated by the magnetic element is accumulated inside the box when the inverter operates, high heat radiation acts on the electronic device inside the box, which is easy to damage the electronic device.

In another arrangement, the electronic device is disposed inside a box, the magnetic element and the heat radiator are disposed in parallel. In addition, a fan is provided to blow the magnetic element and the heat radiator for heat radiation, the cold air blast firstly flows through the heat radiator and then passes the magnetic element. With this arrangement, the magnetic element may block the cold air blast flowed through the heat radiator, therefore the radiation effect of the heat radiator is reduced.

Hence, the radiation effects of the two common arrangements for the inverter in the conventional technology both are not good.

US4772999A discloses a converter, which comprises a plurality of modules each having a heat-sink unit with a base-plate made of a good heat-conducting metal material, acting as a support for the electronic components, a pair of parallel flanges laterally fixed to the opposite edges of the base-plate, and a rear plate for connection of the draw-in contacts capable of cooperating with the studs of a fixed connecting base.

WO2009136815A1 discloses an inverter welding source. The separation panel of the source body is secured between the front and the rear panels thereof, which panels are connected to a base and to a removable cover so as a top section is formed for accommodating therein high- and low-voltage electronic components. A lower section is in the form of an air duct which is provided with a fan and with at least one first and one second radiators for cooling a supply transformer, chokes and power rectifying modules which are arranged therein. The separation panel has openings for mounting the first radiator in such a way that horizontal flat surface thereof is oriented towards the inside of the upper section. The radiators are mounted with the fins thereof positioned vertically with respect to the base and are secured to the separation panel in such a way that the fins are disposed longitudinally with respect to the airflow coming from the fan. The second radiator is attached to the separation panel in such a way that it is vertically offset with respect thereto and a gap is formed. The power rectifying modules are arranged in the above-mentioned gap on the horizontal flat surface of said radiator.

CN202816620U discloses a high-power high-frequency transformer. The transformer comprises an annular magnetic core made of ferrite; the surface of the magnetic core is coated with insulation resin; a primary coil adopts 6 mm² multi-strand enameled wire, a polyester film is arranged outside the wire, and 24 turns are coiled; a secondary coil adopts multiple 25 mm² multi-strand tinsel wires, a high-temperature yellow wax tube is arranged outside the wires, 2 turns are coiled, and the center of each wire is tapped.

EP1283589A2 discloses a power converter module for electrical energy supply in the field of rail transport, comprising a heat sink and a transformer.

### SUMMARY

In view of this, an inverter is provided according to independent claim 1, to solve the problem of poor radiation effect in the conventional technology. Preferable embodiments are recited by the dependent claims.

An inverter according to claim 1 is provided.

Preferably, the first box and the second box may share one mounting plate, and may be located on two parallel mounting surfaces of the mounting plate respectively.

Preferably, the heat radiator may be disposed on the mounting plate inside the second box; and the electronic device may be disposed on the mounting plate inside the first box.

Preferably, the magnetic element may be disposed on the top plate of the second box.

Preferably, the cooling fan may be disposed on the side plate of the second box inside the second box, the side plate may be perpendicular to gaps between fins of the heat radiator.

Preferably, one or more vents may be disposed in another side plate of the second box, the another side plate may be perpendicular to the gaps between the fins of the heat radiator.

Preferably, the number of the vents may be more than one, and the vents may be uniformly disposed at positions corresponding to the gaps between the fins of the heat radiator.

Preferably, the number of the cooling fans may be four.

In the inverter according to the disclosure, the electronic device is disposed inside the first box; the heat radiator and the cooling fan are disposed inside the second box; and the magnetic element is disposed outside the first box and the second box. In this way, the cooling effect on the electronic device inside the first box and the heat radiator inside the second box may be less affected by the heat generated by the magnetic element. The magnetic element being disposed outside the first box and the second box is also beneficial to heat radiation of the magnetic element. The cooling fan only blows the heat radiator for heat radiation, there is not a case that the magnetic element blocks the cold air blast flowed through the heat radiator as in the conventional technology, therefore a more unobstructed air duct is formed, and the radiation effect is improved.

### BRIEF DESCRIPTION OF THE DRAWINGS

The drawings to be used in the description of embodiments of the disclosure or the conventional technology are described briefly as follows, so that technical solutions according to the embodiments of the present disclosure or according to the conventional technology become clearer. It is apparent that the drawings in the following description only illustrate some embodiments of the present disclosure. For those skilled in the art, other drawings may be obtained based on these drawings without any creative work.
Figure 1 is a schematic structural diagram of an inverter according to an embodiment of the disclosure;
Figure 2 is a schematic structural diagram of an inverter according to an embodiment of the disclosure; and
Figure 3 is a schematic structural diagram of a second box according to an embodiment of the disclosure.

### DETAILED DESCRIPTION OF EMBODIMENTS

The technical solution according to the embodiments of the disclosure is described clearly and completely as follows in conjunction with the accompanying drawings.

An inverter is provided according to the disclosure, to solve the problem of the poor radiation effect in the conventional technology.

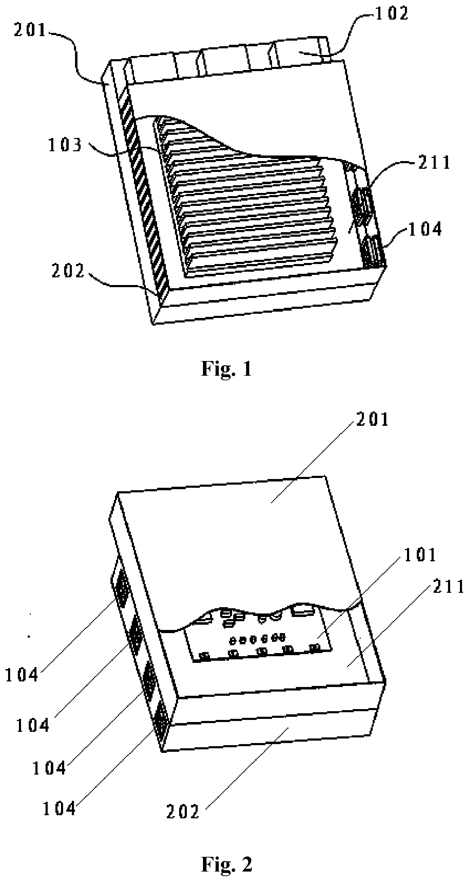

Specifically, as shown in Figure 1 and Figure 2, the inverter includes: an electronic device 101, a magnetic element 102, a heat radiator 103, a cooling fan 104, a first box 201 and a second box 202 connected with each other via a mounting plate 211, where the mounting plate 211 is located between the first box 201 and the second box 202; the electronic device 101 is disposed inside the first box 201; the heat radiator 103 and the cooling fan 104 are disposed inside the second box 202; and the magnetic element 102 is disposed outside the first box 201 and the second box 202.

The magnetic element 102 being disposed outside the first box 201 and the second box 202 may lead to a result that the cooling effect on the electronic device 101 inside the first box 201 and the heat radiator 103 inside the second box 202 is less affected by the heat generated by the magnetic element 102. The magnetic element 102 is disposed outside the first box 201 and the second box 202, and is directly contacted with outside air, the heat generated by the magnetic element 102 is easy to be exchanged with the air, hence the temperature of the magnetic element 102 is reduced, and it is beneficial to heat radiation of the magnetic element 102, the operation efficiency of the magnetic element 102 is improved. The cooling fan 104 only blows the heat radiator 103 for heat radiation, there is not a case that the magnetic element blocks the cold air blast flowed through the heat radiator as in the conventional technology, therefore a more unobstructed air duct is formed, and the radiation effect is improved.

It should be noted that, the magnetic element 102 being disposed outside the first box 201 and the second box 202 leads to a result that the heat radiation of the electronic device 101 inside the first box 201 and the heat radiator 103 inside the second box 202 is less affected by the heat generated by the magnetic element.

In practice, each of the first box 201 and the second box 202 may include the mounting plate 211 to mount a respective device.

Preferably, the first box 201 and the second box 202 share one mounting plate 211, and are located on two parallel mounting surfaces of the mounting plate 211 respectively.

The electronic device 101 and the heat radiator 103 are mounted on two parallel mounting surfaces of the mounting plate 211 respectively, and the two parallel mounting surfaces of the mounting plate 211 may be two surfaces having the largest areas. In practice, the two parallel mounting surfaces of the mounting plate 211 may be two surfaces, for mounting the devices, not having the largest areas, which is not limited herein and defined depending on specific application.

The first box 201 and the second box 202 are respectively disposed on the two parallel mounting surfaces of the mounting plate 211 so that the first box 201 and the second box 202 are connected in a back-to-back way. Taking a cuboid as an example for description, both the first box 201 and the second box 202 have five surfaces, and are mounted on a front surface and a back surface of the mounting plate 211.

Preferably, the heat radiator 103 is disposed on the mounting plate 211 inside the second box 202 (as shown in Figure 1); and the electronic device 101 is disposed on the mounting plate 211 inside the first box 201 (as shown in Figure 2).

As shown in Figure 1 and Figure 2, the heat radiator 103 and the electronic device 101 are disposed at two sides of the mounting plate 211 respectively so that the heat radiator 103 and the electronic device 101 are contacted in a back-to-back way via the mounting plated 211. In this way, the heat radiator 103 can operate well for the heat radiation for the electronic device 101.

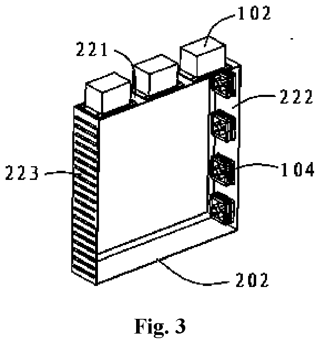

Preferably, as shown in Figure 3, the magnetic element 102 is disposed on a top plate 221 of the second box 202.

A position where the magnetic element 102 is disposed is named as the top plate 221 of the second box 202, and a direction in the description is referred to a placement direction of the inverter when the inverter operates.

The magnetic element 102 is disposed on the top plate 221 of the box and is directly contacted with outside air, the heat generated by the magnetic element 102 is easy to be exchanged with the air, hence the temperature of the magnetic element 102 is reduced, and it is beneficial to heat radiation of the magnetic element 102, the operation efficiency of the magnetic element 102 is improved.

Preferably, as shown in Figure 1, the cooling fan 104 is disposed on a side plate 222 of the second box 202 inside the second box 202, the side plate 222 is perpendicular to gaps between fins of the heat radiator 103.

A position of the second box 202 where the cooling fan 104 is disposed is the side plate 222 of the second box 202 perpendicular to the gaps between the fins of the heat radiator 103. In this way, it is ensured that the cold air blast generated by the cooling fan 104 can flow through the heat radiator 103 in a large area, and it is beneficial to the heat radiation of the heat radiator 103.

Preferably, as shown in Figure 1, one or more vents are disposed in another side plate 223 of the second box 202, the another side plate 223 is perpendicular to the gaps between the fins of the heat radiator 103.

Preferably, as shown in Figure 1, the number of the vents is more than one, and the vents are uniformly disposed at positions corresponding to the gaps between the fins of the heat radiator 103.

The positions corresponding to the gaps between the fins of the heat radiator 103 correspond to projection of the gaps between the fins of the heat radiator 103 on the side plate 223.

The cooling fan 104 and the vents are disposed at two sides of the heat radiator 103 respectively, so that the cold air blast generated by the cooling fan 104 can pass the gaps between the fins of the heat radiator 103 and the vents, thus an unobstructed air duct can be formed, and it is beneficial to the heat radiation of the heat radiator 103.

In practice, the number and positions of the vents may depend on the specific application, which is not limited herein.

Preferably, as shown in Figure 2 and Figure 3, the number of the cooling fans 104 is four.

In practice, the number of the cooling fans 104 is not limited. The cooling fans 104 shown in the drawings show only an example, and the number of the cooling fans 104 may depend on the specific application.

The embodiments of the specification are described in a progressive manner, with the emphasis of each of the embodiments on the difference from the other embodiments. Hence, for the same or similar parts between the embodiments, one embodiment can be understood with reference to the other embodiments.

The description of the embodiments herein enables those skilled in the art to implement or use the present disclosure. The invention is not limited to the embodiments described herein, but is defined by the appended claims.

## Claims

1. An inverter comprising: an electronic device (101), a magnetic element (102), a heat radiator (103), one or more cooling fans (104), a first box (201) and a second box (202) connected with each other via a mounting plate (211), wherein
the mounting plate (211) is located between the first box (201) and the second box (202); the electronic device (101) is disposed inside the first box (201);
the heat radiator (103) and the one or more cooling fans (104) are disposed inside the second box (202);
the magnetic element (102) is disposed outside the first box (201) and the second box (202) and is configured to be air cooled,
the second box (202) comprises a side plate (222, 223) and a top plate (221), and the side plate (222, 223) and the top plate (221) are perpendicular to the mounting plate (211); and
wherein the second box is configured such that it comprises an air duct that allows an air flow that is generated by the one or more cooling fans (104) to flow through the heat radiator (103), and the inverter is configured such that the air flow is not obstructed by the magnetic element (102).

2. The inverter according to claim 1, wherein the first box (201) and the second box (202) share the mounting plate (211), and are located on two parallel mounting surfaces of the mounting plate (211) respectively.

3. The inverter according to claim 1 or 2, wherein the heat radiator (103) is disposed on the mounting plate (211) inside the second box (202); and the electronic device (101) is disposed on the mounting plate (211) inside the first box (201).

4. The inverter according to claim 1 or 2, wherein the magnetic element (102) is disposed on the top plate (221) of the second box (202).

5. The inverter according to claim 1 or 2, wherein the cooling fan (104) is disposed on the side plate (222) of the second box (202) inside the second box (202), the side plate (222) is perpendicular to gaps between fins of the heat radiator (103).

6. The inverter according to claim 5, wherein one or more vents are disposed in another side plate (223) of the second box (202), the another side plate (223) is perpendicular to the gaps between the fins of the heat radiator (103).

7. The inverter according to claim 6, wherein the number of the vents is more than one, and the vents are uniformly disposed at positions corresponding to the gaps between the fins of the heat radiator (103).

8. The inverter according to claim 1 or 2, wherein the number of the cooling fans (104) is four.

## Patentansprüche

1. Wechselrichter, umfassend: eine elektronische Vorrichtung (101), ein magnetisches Element (102), einen Wärmestrahler (103), ein oder mehrere Kühlgebläse (104), einen ersten Kasten (201) und einen zweiten Kasten (202), die über eine Montageplatte (211) miteinander verbunden sind, wobei
sich die Montageplatte (211) zwischen dem ersten Kasten (201) und dem zweiten Kasten (202) befindet;
die elektronische Vorrichtung (101) im Inneren des ersten Kastens (201) angeordnet ist;
der Wärmestrahler (103) und das eine oder die mehreren Kühlgebläse (104) im Inneren des zweiten Kastens (202) angeordnet sind;
das magnetische Element (102) außerhalb des ersten Kastens (201) und des zweiten Kastens (202) angeordnet ist und dazu ausgelegt ist, luftgekühlt zu werden,
der zweite Kasten (202) eine Seitenplatte (222, 223) und eine obere Platte (221) umfasst und die Seitenlatte (222, 223) und die obere Platte (221) senkrecht zu der Montageplatte (211) sind; und
wobei der zweite Kasten derart ausgelegt ist, dass er einen Luftkanal umfasst, der es ermöglicht, dass ein Luftstrom, der durch das eine oder die mehreren Kühlgebläse (104) erzeugt wird, durch den Wärmestrahler (103) strömt, und der Wechselrichter derart ausgelegt ist, dass der Luftstrom nicht durch das magnetische Element (102) behindert wird.

2. Wechselrichter nach Anspruch 1, wobei sich der erste Kasten (201) und der zweite Kasten (202) die Montageplatte (211) teilen und jeweils auf zwei parallelen Montageflächen der Montageplatte (211) angeordnet sind.

3. Wechselrichter nach Anspruch 1 oder 2, wobei der Wärmestrahler (103) auf der Montageplatte (211) im Inneren des zweiten Kastens (202) angeordnet ist; und die elektronische Vorrichtung (101) auf der Montageplatte (211) im Inneren des ersten Kastens (201) angeordnet ist.

4. Wechselrichter nach Anspruch 1 oder 2, wobei das magnetische Element (102) auf der oberen Platte (221) des zweiten Kastens (202) angeordnet ist.

5. Wechselrichter nach Anspruch 1 oder 2, wobei das Kühlgebläse (104) auf der Seitenplatte (222) des zweiten Kastens (202) im Inneren des zweiten Kastens (202) angeordnet ist, wobei die Seitenplatte (222) senkrecht zu Zwischenräumen zwischen Rippen des Wärmestrahlers (103) ist.

6. Wechselrichter nach Anspruch 5, wobei eine oder mehrere Entlüftungsöffnungen in einer anderen Seitenplatte (223) des zweiten Kastens (202) angeordnet sind, wobei die andere Seitenplatte (223) senkrecht zu den Zwischenräumen zwischen den Rippen des Wärmestrahlers (103) ist.

7. Wechselrichter nach Anspruch 6, wobei die Anzahl der Entlüftungsöffnungen mehr als eins beträgt und die Entlüftungsöffnungen gleichmäßig an Positionen angeordnet sind, die den Zwischenräumen zwischen den Rippen des Wärmestrahlers (103) entsprechen.

8. Wechselrichter nach Anspruch 1 oder 2, wobei die Anzahl der Kühlgebläse (104) vier beträgt.

## Revendications

1. Convertisseur comprenant : un dispositif électronique (101), un élément magnétique (102), un radiateur thermique (103), un ou plusieurs ventilateurs de refroidissement (104), un premier boîtier (201) et un second boîtier (202) reliés l'un à l'autre par l'intermédiaire d'une plaque de montage (211), dans lequel
la plaque de montage (211) est située entre le premier boîtier (201) et le second boîtier (202) ;
le dispositif électronique (101) est disposé à l'intérieur du premier boîtier (201) ;
le radiateur thermique (103) et les un ou plusieurs ventilateurs de refroidissement (104) sont disposés à l'intérieur du second boîtier (202) ;
l'élément magnétique (102) est disposé à l'extérieur du premier boîtier (201) et du second boîtier (202) et est configuré pour être refroidi par l'air,
le second boîtier (202) comprend une plaque latérale (222, 223) et une plaque supérieure (221), et la plaque latérale (222, 223) et la plaque supérieure (221) sont perpendiculaires à la plaque de montage (211) ; et
dans lequel le second boîtier est configuré de telle sorte qu'il comprend un conduit d'air qui permet à un flux d'air généré par les un ou plusieurs ventilateurs de refroidissement (104) de s'écouler à travers le radiateur thermique (103), et le convertisseur est configuré de telle sorte que le flux d'air n'est pas obstrué par l'élément magnétique (102).

2. Convertisseur selon la revendication 1, dans lequel le premier boîtier (201) et le second boîtier (202) partagent la plaque de montage (211) et sont situés respectivement sur deux surfaces de montage parallèles de la plaque de montage (211).

3. Convertisseur selon la revendication 1 ou 2, dans lequel le radiateur thermique (103) est disposé sur la plaque de montage (211) à l'intérieur du second boîtier (202) ; et le dispositif électronique (101) est disposé sur la plaque de montage (211) à l'intérieur du premier boîtier (201).

4. Convertisseur selon la revendication 1 ou 2, dans lequel l'élément magnétique (102) est disposé sur la plaque supérieure (221) du second boîtier (202).

5. Convertisseur selon la revendication 1 ou 2, dans lequel le ventilateur de refroidissement (104) est disposé sur la plaque latérale (222) du second boîtier (202) à l'intérieur du second boîtier (202), la plaque latérale (222) est perpendiculaire aux espaces entre les ailettes du radiateur thermique (103).

6. Convertisseur selon la revendication 5, dans lequel une ou plusieurs aérations sont disposées dans une autre plaque latérale (223) du second boîtier (202), l'autre plaque latérale (223) est perpendiculaire aux espaces entre les ailettes du radiateur thermique (103).

7. Convertisseur selon la revendication 6, dans lequel le nombre d'aérations est supérieur à un, et les aérations sont disposées uniformément dans des positions correspondant aux espaces entre les ailettes du radiateur thermique (103).

8. Convertisseur selon la revendication 1 ou 2, dans lequel le nombre de ventilateurs de refroidissement (104) est de quatre.
